# EUROPEAN PATENT APPLICATION

(11) **EP 2 355 167 A2**
(43) Date of publication of application: **10.08.2011**
(21) Application number: 09827715.5
(22) Date of filing: 18.11.2009
(51) Int. Cl.: H01L 31/042

(54) **METHOD FOR MANUFACTURING ELECTRODE FOR SOLAR CELL, SUBSTRATE FOR SOLAR CELL MANUFACTURED BY THE SAME, AND SOLAR CELL MANUFACTURED BY THE SAME**

(30) Priority: 18.11.2008 KR 20080114344
(71) Applicant: SSCP Co., Ltd., Ansan-si, Gyeonggi-do 425-833 (KR)
(72) Inventor: LEE, Su Jin, Incheon-si 406-050 (KR); KANG, Ghi Yuun, Seoul 136-770 (KR); JUNG, Hyun Min, Seongnam-si Gyeonggi-do 463-703 (KR); LEE, Dae Sung, Gunpo-si Gyeonggi-do 435-705 (KR)
(74) Representative: Gesthuysen, von Rohr & Eggert
(86) International application number: PCT/KR2009/006783
(87) International publication number: WO 2010/058950

(57) **Abstract**

The present invention provides a method for manufacturing an electrode for a solar cell, a substrate for the solar cell manufactured by the same, and a solar cell manufactured by the same. The present invention forms an electrode of a specific pattern through an offset printing system, and plates the electrode through a plating process to fill the metal-free region of a bus bar electrode with a plating metal and thus reduce the sheet resistance of the bus bar. The present invention obtains a finger electrode with a line with 100 microns or less through the combination of an offset printing process and a wet metal plating process. Further, the present invention obtains an electrode with an aspect ratio of 0.2 to 0.6 to reduce light shield effects and improve efficiency of the solar cell. The present invention eliminates the necessity of multilayer offset printing, and thus to reduce use of expensive conductive paste with might otherwise increase in proportion to the number of times printing is performed.

## Description

### Technical Field

The present invention relates to a method for manufacturing an electrode for a solar cell, a substrate for a solar cell by using the same, and a solar cell by using the same.

### Background Art

A solar cell is a semiconductor device for converting a solar energy to an electric energy. The solar cell has a p-n junction, and the fundamental structure thereof is the same as a diode. When a light is incident into the solar cell, the incident light is absorbed to the solar cell and is interacted with a material constituting the semiconductor. As a result, electrons and holes as minority carriers are formed, and they move to connected electrodes of both sides, thereby obtaining electromotive force.

Generally, crystalline silicon solar cells may be largely classified into a single crystal type and a polycrystalline type. A material of the single crystal type has a high efficiency due to a high purity and a low defect density, but the material of the single crystal type is expensive. Although a material of the polycrystalline type has a slightly low efficiency compared with the material of the single crystal, but it is generally used because it is relatively cheap.

A method for manufacturing the polycrystalline silicon solar cell is as follows. The p type polycrystalline silicon substrate with a certain size (for example, 5" or 6") and a thickness (for example, 150 to 250µm) is etched by a proper etching method in order to eliminate defects of a surface of the substrate and to provide roughness. Next, a material including phosphorus or POCl3 is supplied in a gaseous phase or a liquid phase, and the phosphorus is doped with a certain thickness (0.1 to 0.5µm) by a thermal diffusion into the surface of the p type substrate. Then, an n type of emitter of 40 to 100Ω/(Ω/square) is formed. After that, so as to remove the by-product such as vitreous material including phosphorus generated during the process, a wet etching process using an acid or a base is included. Also, in order to eliminate the phosphorous at the rest portion except for the front portion where the light is incident, a dry etching using plasma is included. Selectively, in some cases, a process for cutting an edge surface through using a laser may be included. After that, the crystalline or amorphous silicon nitride, silicon oxide, titanium oxide, or the combination thereof is deposited by a physical vapor deposition with a proper thickness (70 to 90Å in the case of the silicon nitride) considering a refractive index of the deposited material. Then, an electrode of the P type semiconductor and an electrode of the N type are formed.

### Disclosure

### Technical Problem

Related to the formation of the electrodes, the present inventors consider that an electrode pattern is formed by using a photo resist on a surface of a semiconductor wafer and then a metal deposition layer is formed by a deposition process. However, in the method using the photo resist, the metal deposition layer except for a portion constituting an underlayer electrode should be removed after the deposition process, and the photo resist layer should be also removed. Further, since the underlayer electrode layer is formed by the deposition method, the adhesion with the semiconductor wafer is weak.

Meanwhile, the method for improving the adhesion problem at the single crystal silicon wafer is considered as follows. In the method, electroless nickel-phosphorus plating layer including phosphorus P as n type dopant is formed at the P type of silicon layer, and electroless nickel-boron plating layer including boron B as p type dopant is formed at the N type of silicon layer. And then, alloy layers between the nickel plating layers and the silicon wafer are formed through the heat treatment.

However, in the case that the plating layer is formed by using the plating solution including the actual dopant, the electrode having the dopant is formed on the whole portion as well as the contacted portion. Thus, the line resistance is actually lower than that of an electrode using silver for the conventional printing. Thus, there is a problem that the serial resistance of the whole cell is increased. Also, in order to form the electrode pattern for the plating, the photo lithography process should be additionally performed before the plating.

As conventional electrode printings, there are a screen printing, an offset printing, an inkjet printing, and so on. Until now, the screen printing method is generally suggested for manufacturing an electrode for a solar cell, and the electrode has a relatively wide line width (100µm or more). However, a fine line width cannot be obtained by the screen printing method.

It is known that the inkjet printing cannot be applied to the method for manufacturing the electrode for the solar cell until now. That is, it is known that the inkjet printing does not have an industrial application. In order to use the inkjet printing method, a conductive ink having a satisfied property for the electrode for the solar cell and having a viscosity suitable for the inkjet printing method should be developed in advance. The conductive ink for the electrode for the solar cell is undeveloped.

In order to solve the above problem, the present invention provides a method for manufacturing an electrode for a solar cell, a substrate for a solar cell manufactured by using the same, and a solar cell manufactured by using the same. In the present invention, an electrode with a fine line width can be formed by using the offset printing process that has a high productivity. Also, in the present invention, the electrode has a high electrical property by remedying the weakness of the conventional offset printing method.

### Technical Solution

To achieve the above, the present invention provides a substrate for a solar cell including a plurality of bus bar electrodes and finger electrodes formed on a front surface of the substrate. Here, the bus bar electrodes and the finger electrodes are formed by an offset printing using a conductive paste and a plating after the offset printing. The conventional constitutions of the substrate for the solar cell can be applied and added to the present invention when they are possible to be realized at the present invention, and they are included in the present invention. For example, the bus bar electrodes and the finger electrodes may be perpendicularly crossed with and be adjacent to each other. A rear electrode may be included on a rear surface of the substrate. Also, a kind of the substrate is not limited, and the substrate includes all substrates that can be used for the solar cell.

Also, the bus bar electrodes are offset-printed to have a mesh shape having fine pores. If necessary, the finger electrode can be formed by a mesh shape, similar to the bus bas electrodes.

When the substrate for the solar cell is formed, the offset printing may be performed only once, and the bus bar electrodes and the finger electrodes may be printed at the same time. A firing may be performed after the offset printing, and the plating may be performed after the firing. Also, a plated metal is heat-treated after the plating.

The substrate for the solar cell of the present invention, the finger electrodes may have an aspect ratio (height/line width) of 0.2 to 0.6. Also, the finger electrodes have a line width of 30µm to 100µm and a height of 5µm to 20µm.

Also, the present invention provides a solar cell manufactured by using the substrate. Here, an efficiency of the solar cell according to the present invention is twice or more of that of a solar cell manufactured by using a substrate for a solar cell having electrodes formed by an offset printing without a plating after the offset printing.

In addition, the present invention provides a solar cell manufactured by using the substrate.

Further, the present invention provides a method for manufacturing bus bar electrodes and finger electrodes on a substrate including a paste-electrode printing step for printing the bus bar electrodes and the finger electrodes on the substrate by an offset method using a conductive paste; an electrode plating step for filling fine pores of the paste-electrode with an additional metal by dipping the paste-electrode into a plating solution, after the paste-electrode printing step; and a heat treatment step for heat-treating to form an ohmic contact, after the electrode plating step.

The present invention provides a method for manufacturing an electrode for a solar cell further comprising a firing step for firing the electrode after the paste-electrode printing step.

The present invention provides a method for manufacturing an electrode for a solar cell that the bus bar electrodes may be offset-printed once to have a mesh shape having fine pores.

Still Further, the present invention provides a solar cell comprising the electrode for the solar cell manufactured by the above method. Here, the solar cell has a cell efficiency (Eff) of 10% or more, a fill factor (FF) of 50% or more, and a serial resistance (Rser) of 0.02Ω or less.

### Advantageous Effects

A method for manufacturing an electrode for a solar cell according to the present invention can be simple, have a high productivity, and provide a fine line width. According to the present invention, the electrode is formed through an offset printing (preferably, a bus bar electrode is printed to have a mesh shape), and a metal-free region is filled with a plating metal by plating an additional metal layer through a wet metal printing method. Thus, a sheet resistance of the bus bar is particularly reduced. A finger electrode can have a line width within 100 microns and an aspect ratio of 0.2 to 0.6 through the combination of the offset printing process and the wet metal plating process, and thus a light shield effect can be reduced. By forming an additional ohmic contact between the plated metal and a silicon after through a heat treatment after the plating. Finally, an efficiency of the solar cell can be improved.

In addition, by applying the additional wet metal plating process, the necessity of multilayer offset printing two times or more for increasing the cell efficiency of the solar cell can be eliminated. Thus, the use of an expensive conductive paste which might increase in proportion to the number of times printing is performed can be reduced.

### BRIEF DESCRIPTION OF DRAWINGS

FIG. 1 to FIG. 3 illustrate schematic perspective or cross-sectional views of a substrate for a solar cell including a plurality of bus bar electrodes and finger electrodes connected to the bus bar electrodes formed on a front surface of the substrate in an embodiment of the present invention, according to a manufacturing procedure.
FIG. 4 and FIG. 5 schematically illustrate an offset printing and a shape of the bus bar electrodes having a mesh shape including fine pores in the embodiment of the present invention.
FIG. 6 illustrates SEM(scanning electron microscope) photographs of bus bar electrodes after a offset printing (a) and after a wet metal plating (b) when the bus bar electrodes are etched.
FIG. 7 illustrates photographs (X100) of line widths of finger electrodes manufactured according to Embodiment 1, Embodiment 2, and Comparative Example 1.

### ** Descriptions regarding main reference signs in drawings **

1: substrate
2: bus bar electrode
3: finger electrode
4: plated layer

### Best Mode

Hereinafter, with reference to drawings and embodiments, the present invention will be described in more detail. The below descriptions relate to specific examples of the present invention. Thus, even though there are conclusive and/or limitative terms or expressions, they do not limit the scope of the present invention that is determined by claims.

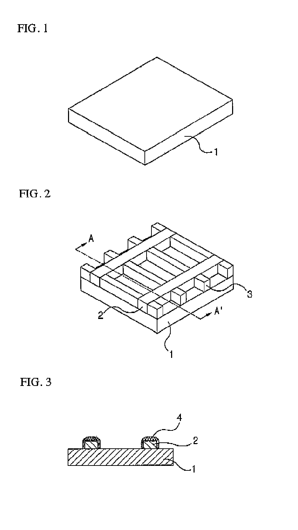

In order to minimize shielding of sunlight and to increase an efficiency, it is necessary that finger electrodes connected to bus bar have a decreased line width and an increased aspect ratio. So as to achieve the above, the present inventors have studied a method for manufacturing an electrode pattern by an offset printing method. However, at the conventional offset printing, although finger electrode that is needed to have the the fine line width within 100µm can be obtained to have the wanted fine line width, a set process cannot be performed well when the bus bar electrodes of wide line width are printed. As one method for performing the set process well, it is found that the set process can be performed well when the bus bar electrodes have a mesh shape having fine pores as shown in FIG. 2a. Also, the fine line width of the finger electrode can be achieved.

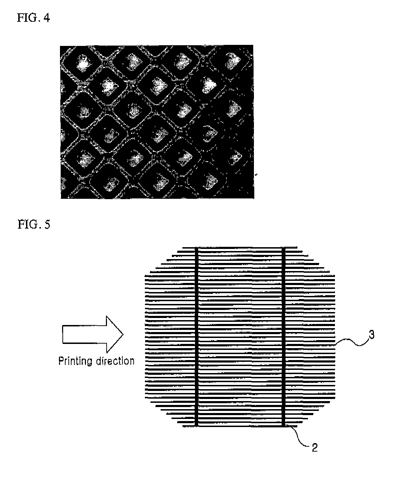

One reason why the set process at the wide line width is not performed well during the conventional offset printing is because a doctor blade may be bounced at bus bars 2a when doctoring of the doctor blade is carried out in a horizontal direction, as shown in FIG. 5.

When the bus bars 2 have the mesh shape in order to improve the problem of bounce of the blade, the printability is increased. However, during the printing, conductive paste layers are stacked to have the mesh shape, and thus the electrode has a non-uniform thickness. Thus, the sheet resistance and the line resistance are increased. Also, after firing, an ohmic contact area between a silicon wafer layer and the conductive paste layer is decreased. Therefore, the efficiency of the solar cell may be reduced.

In the case that the electrode of the solar cell is manufactured by the above offset printing method, so as to increase the aspect ratio of the electrode and the efficiency of the solar cell, the offset printing should be performed two times or more and the electrode has a plurality of layers. Then, the cost of production is largely increased. In addition, even though the offset printing is performed two times or more, the pores between metal particles exist inside of a metal layer for a front electrode and the line resistance cannot be sufficiently improved.

In order to resolve the above problems, in the present invention, a conductive front electrode with small line width is formed by an offset method on a substrate, and the substrate is dipped into the plating solution to be plated. Then, pores between metal particles in the metal electrode are filled with the plating metal. As a result, the line resistance of the finger electrode can be reduced. Particularly, the portion that the conductive paste is not stacked at the bus bar electrode of a mesh shape is filled with the plating metal, thereby increasing the ohmic contact area of the bus bar electrode. Also, the bus bar electrode is densified by an additional heat treatment process, and the efficiency of the solar cell can be increased.

FIG. 1 to FIG. 3 illustrate schematic perspective or cross-sectional views of a substrate for a solar cell including a plurality of bus bar electrodes and finger electrodes connected to the bus bar electrodes formed on a front surface of the substrate in an embodiment of the present invention, according to a manufacturing procedure. As shown in drawings, bus bar electrodes 2 and finger electrodes 3 as paste electrodes are formed through offset-printing a conductive paste on a substrate 1(FIG. 2). Next, a plated layer 4 is formed by plating (FIG. 3). The bus bar electrodes 2 and the finger electrodes 3 as the paste electrodes may be subjected to a firing process before the plating. Also, the plated layer 4 may be heat-treated after the plating.

The electrode formed on the substrate may be formed by an exemplary method as follows. That is, in the method for manufacturing the bus bar electrodes and the finger electrodes for a solar cell, the bus bar electrodes and the finger electrodes may be formed by the method including a paste-electrode printing step, an electrode plating step, and a heat treatment step. In the paste-electrode printing step, the bus bar electrodes and the finger electrodes are formed on the substrate by an offset method using the conductive paste. In the electrode plating step after the paste-electrode printing step, the fine pores of the paste-electrode are filled with additional metal by dipping the paste-electrode into the plating solution. In the heat treatment step after the electrode plating step, the bus bar electrodes and the finger electrodes are heat-treated to form an ohmic contact. Also, a firing step for firing the electrode may be further carried out between the paste-electrode printing paste and the plating step.

The materials known in the art may be used for the conductive paste used at the electrode printing, and thus the conductive paste is not limited. The pastes having silver, copper, nickel, aluminum, and so on as a main component are generally used. Mostly, the silver paste including a silver powder may be used. Concretely, it is preferable that the silver paste includes 60 to 85 wt% of the silver powder, 3 to 20 wt% of a glass powder, 2 to 10 wt% of a binder with a high molecule, 3 to 20 wt% of a diluting solution, and 0.1 to 5 wt% of additives, because it is suitable for the offset printing.

As the printing method of the conductive paste, there are a screen printing method, an offset printing method, an inkjet printing method, and so on. In the inkjet printing method, the printing thickness is below 5µm, and there is a limitation on the thickness control. Also, since the material with a low viscosity below 50 cPs is suitable for the printing, the conductive paste that the metal powder is included above 60% and has a high viscosity is not proper for the printing. The screen printing is mostly used, but the line width of the formed electrode is over 100µm that is relatively wide. Therefore, when the electrode is used as the front electrode of the solar cell, the ratio in area shielded by the front electrode (light shield effect or shading loss) is increased. As a result, the efficiency of the solar cell may be reduced.

Accordingly, in the present invention, as the method for manufacturing the front electrode for the solar cell, the offset printing which is different from the screen printing and the inkjet printing is applied.

More preferably, in the offset printing method, the bus bar electrode pattern having the mesh shape is applied as shown in FIG. 4. The mesh shape is optimized for the offset printability, and thus the bounce of the blade at the bus bar can be prevented. The mesh shape defined in the present invention includes all patterns having fine pores. The fine pores may have various shapes such as a rectangular shape, a triangular shape, a hexagonal shape, a circular shape, a random shape, and a dot shape.

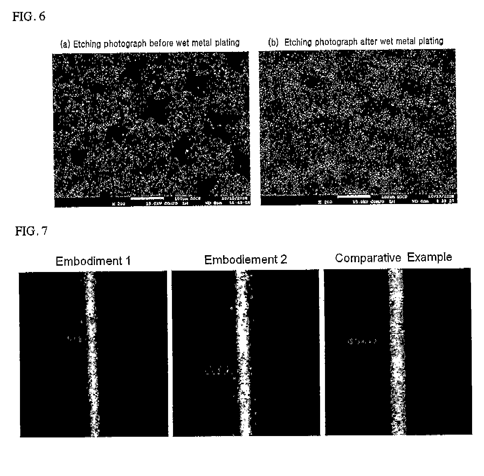

In addition, it is preferable that the electrode pattern for the solar cell may be printed by one-time offset printing using the conductive paste (However, the present invention is not limited to the one-time printing). Thus, the bus bar electrodes and the finger electrodes may be printed at the same time. When the offset printing is performed once, since the number of the printing is reduced, the process is simple and the amount of the expensive conductive paste is reduced. However, as shown in FIG. 6, because the bus bar patterns with the mesh method has the portion where the conductive paste is not filled, the bus bar patterns has the increased sheet resistance and the increased line resistance. Also, because the ohmic contact with the silicon wafer is not sufficient after the firing, the efficiency of the solar cell may be reduced. However, the present invention has a unique method so that the above problem can be resolved and the electrode with the high performance can be obtained. This will be described later.

More preferably, after the paste-electrode printing step, the firing step for firing the electrode may be added. By the firing, the insulating material such as the binder with the high molecule and the solvent can be removed from the paste composition. Thus, the electrical property can be enhanced. The firing may be carried out at a temperature of 600 to 900°C for several seconds to several hours. However, the condition of the firing is not limited.

Subsequently, through the plating process, the additional plated metal layer is formed at the conductive paste electrode. When the additional plated metal layer is formed at the conductive paste electrode through the plating process, the portion where the conductive paste of the bus bar patterns with the mesh shape is not stacked is filled with the plated metal as shown in FIG. 7. Also, the conductive paste electrode having the metal powder with a diameter of 1 microns or more has a lot of fine pores between the metal particles, and the densified plated metal fills the fine pores. Thus, the sheet resistance and the line resistance of the electrode can be remarkably reduced. Further, since the additional wet metal plating process is applied, the offset printing of two times or more is not necessary in order to increase the efficiency of the solar cell. Accordingly, the used amount of the expensive conductive paste, which is increased depending on the number of the printing, can be reduced.

The wet metal plating is preferable for the plating process. However, the method of the plating process is not limited. The wet metal plating may be generally classified into an electroless plating method and an electro plating method. The electroless plating method is generally used to provide conductivity to the surface, which is generally an insulator. In the electroless plating, the metal is reduced by using electron released through an oxidation-reduction reaction in a solution where a metallic salt and a soluble reductant coexist, thereby plating the metal. Generally, in the electroless plating, the plating is performed by a selective reduction reaction on a catalyst surface or catalysis of the metal itself of the plated layer. The electro plating is generally used. In the electro plating, the surface of an object to be plated should be a conductive surface. The electro plating is performed by plating the metal on the conductive surface as the negative pole through using an external power.

According to the embodiment of the present invention, since the object to be plated is the electrode consisting of the conductive paste, both of the electroless plating method and the electro plating method can be applied. Thus, electroless plating method, the electro plating method, or both of the electroless plating method and the electro plating method may be subjected as the method for plating the additional metal on the conductive paste.

Also, according to the embodiment of the present invention, the plated metal during the wet metal plating process may be a metal having a low resistivity. The plated metal may include at least one selected from a group consisting of silver, gold, copper, nickel, tin, and so on. However, the plated metal is not limited thereto.

Further, as a preferable embodiment, the ohmic contact may be formed by the heat treatment after the electrode plating step. In the heat treatment, the plated metal is heat-treated at a temperature of 400 to 700 °C for several seconds to several hours. However, the condition of the heat treatment is not limited thereto.

The heat treatment relates to the densification of the plated metal. When the temperature of the heat treatment is below 400°C, the densification of the metal particles inside the pores is not sufficient, the pores still exist. When the temperature of the heat treatment is above 700°C, p-n junction of the conductive paste may be broke, and the leakage current is increased. Finally, the cell efficient may be reduced.

When the electrode is manufacture by the above, the finger electrodes can have an aspect ratio (height/line width) of 0.2 to 0.6. The finger electrodes can have a fine line width of 30µm to 100µm and a height of 5µm to 20µm,

In addition, it can be seen that the solar cell using electrodes formed with the plating has a largely-increased efficiency, which is twice or more of that of a solar cell including electrodes formed by an offset printing without the plating after the offset printing. The solar cell using electrodes manufactured by the manufacturing method according to the present invention has a cell efficiency (Eff) of 10% or more, a fill factor (FF) of 50% or more, and a serial resistance (Rser) of 0.02Ω or less, even though the offset printing method is applied.

### <Embodiments>

Hereinafter, the present invention will be described through Embodiments in more detail. However, below Embodiments are only examples of the present invention. Thus, the present invention is not limited thereto.

### Embodiment 1

Firstly, a gravure offset printing was subjected by using a paste composition for an offset (68% of silver powder, 17% of glass frit, 10% of binder, 3% of diluting solvent, 2% of dispersing agent and so on). A doctoring state was check by an initial blade pressure and angle of a gravure roll, and an off pressure and a set pressure were optimized by controlling off nip and set nip of a blanket roll. After 20g of the paste was added to between the gravure roll and the blade, the doctoring was carried out with about 7rpm. After doctoring three times or more, the paste was off to a rubber on the blanket roll, and then the blanket roll was rotated once. During the rotation of the blanket roll, the paste absorbed to the rubber was set with a velocity of 7rpm. By the above method, the conductive paste was printed once on 5" wafer fixed to a printing plate by vacuum. After the printed substrate was dried, the printed substrate was fired at about 800°C for 20 seconds with a velocity of 190 rpm at an infrared furnace. Then, a portion where the electric current would be applied for electro plating was connected to an aluminum electrode layer as a rear electrode. In the state that the whole portion of the rear electrode except for the portion where the electric current would be applied was masked in order to prevent of permeation of the plating solution, a wet metal plating was carried out. Electro silver plating was subjected as the wet metal plating process. The silver plating solution was formed with 25g/l of silver potassium cyanide as a silver metallic salt, 75g/l of potassium cyanide for a metallic complex salt, 30g/l of potassium carbonate for an electrical conductivity and an uniformity of an electrodepostion, and 4g/l of an additive of Argalux64 (maded by Atotec Korea) for a density and a gloss of the plated layer. The substrate was dipped to the silver plating solution, and a silver plated layer was formed at a bath temperature of 25°C, a current density of 1.0A/dm2, and a plating time of 10 minutes in the state that the current was applied by using a silver plate as a positive pole. Then, the plated wafer was heat-treated at a temperature of 550°C for 10 minutes, thereby forming the electrodes for the solar cell. Next, the plated wafer was put to an I-V test apparatus (made by PASAN, CT801), and an cell efficient, a fill factor, a Voc, an Isc, a serial resistance, and a shunt resistance were measured. The results are shown in Table 1.

In order to evaluate the cell of the solar cell, the I-V test apparatus was used. Main measuring factors of the I-V test apparatus were the open-circuit voltage (Voc), the short-circuit current (Isc), the fill factor (FF), the cell efficiency (%), the serial resistance (Rser), and the parallel resistance (or shunt resistance) (Rsh). Here, the Voc is a voltage between two terminals of the cell at an open state that there is no external load connected under a certain temperature and a certain intensity of sunlight. The Isc is an output current from the cell at a short circuit state under a certain temperature and a certain intensity of sunlight. The FF relates to the cell efficiency. The cell efficiency is a barometer for showing how much energy [Watt] can be generated from the cell based on solar energy [Watt] incident from the sun. When the FF is 100%, the I-V curve has a totally rectangular shape, and an ideal power (Pmax) is obtained by multiplying the Isc and the Voc. However, the actual FF is decreased by the serial resistance and the parallel resistance of an inside of the cell and it is difficult to obtain the sufficient Pmax. The serial resistance is a key factor among factors decreasing the fill factor, and the serial resistance affects largely to the Isc. The serial resistance is a sum of a substrate resistance, a contact resistance between silicon and a front electrode, an emitter resistance, and a resistance of the electrode metal itself. Generally, the cell efficiency is high when the serial resistance is low and the fill factor is high.

### Embodiment 2

The process was performed as in Embodiment 1, except that electro copper plating and electroless silver plating were subjected as the wet metal plating process. The electro cupper plating solution was formed with 220g/l of copper sulfate as a metallic salt and 60ml/l of a sulfuric acid. The substrate was dipped to the copper plating solution, and a cupper plated layer was formed at a bath temperature of 25°C, a current density of 0.5A/dm2, and a plating time of 10 minutes in the state that the current was applied by using a cupper plate as a positive pole. Also, the substrate was dipped into the silver plating solution as in Embodiment 1 for 5 minutes, and an electroless silver plating layer was finally formed in the state that the current was not applied. At the electroless silver plating, a principal of a displacement plating according to differences in ionization tendency between the cupper plated metal layer and the silver plating solution was used.

### Comparative Example 1

The conductive paste was offset-printed once by the method of Embodiment 1, and the wet metal plating process was not performed. Then, the plated wafer was put to an I-V test apparatus (made by PASAN, CT801), and a cell efficient, a fill factor, a Voc, an Isc, a serial resistance, and a shunt resistance were measured.

**[Table 1]**

| | Embodiment 1 | Embodiment 2 | Comparative Example 1 |
|---|---|---|---|
| Material of the plated metal | Ag | Cu-Ag | None |
| Thickness of plated metal [µm] | 5.51 | 7.25 | None |
| Total line width of finger electrode [µm] | 52.17 | 56.91 | 31.84 |
| Total height of finger electrode [µm] | 10.35 | 11.83 | 4.50 |
| Aspect ratio of finger electrode (height/line width) | 0.20 | 0.21 | 0.14 |
| Cell efficiency[%] | 14.7 | 15.42 | 6.21 |
| Fill factor[%] | 67.22 | 70.45 | 35.87 |
| Isc[A] | 5.456 | 5.463 | 4.357 |
| Voc[V] | 0.621 | 0.621 | 0.615 |
| Rser[Ω] | 0.0150 | 0.0115 | 0.0594 |
| Rsht[Ω] | 7.3 | 10.6 | 0.3 |

In Embodiment 1 and 2, after the conductive paste-electrode was formed by offset-printing the conductive paste once on the semiconductor wafer and it was fired, the wet metal plating was performed. In Comparative Example 1, after the conductive paste-electrode was formed by offset-printing the conductive paste once on the semiconductor wafer and it was fired, the wet metal plating was not performed. As shown in Table 1, when comparing Embodiments 1 and 2 with Comparative Example, the finger electrode where the wet metal plating was performed has a large aspect ratio and the high efficiency. Here, the efficiency shows an electrical property of the cell.

### Industrial Applicability

A method for manufacturing an electrode for a solar cell according to the present invention can be simple, have a high productivity, and reduce a sheet resistance of a bus bar electrode. Also, a finger electrode can have a line width within 100 microns and an aspect ratio of 0.2 to 0.6, and thus a light shield effect can be reduced. By forming an additional ohmic contact between a plated metal and a silicon wafer through a heat treatment after the plating, an efficiency of a solar cell can be improved. Accordingly, the present invention is industrially useful.

## Claims

1. A substrate for a solar cell comprising a plurality of bus bar electrodes and finger electrodes formed on a front surface of the substrate,
wherein the bus bar electrodes and the finger electrodes are formed by an offset printing using a conductive paste and a plating after the offset printing.

2. The substrate of claim 1, wherein the bus bar electrodes are offset-printed to have a mesh shape having fine pores.

3. The substrate of claim 1, wherein the offset printing is performed only once, and the bus bar electrodes and the finger electrodes are printed at the same time.

4. The substrate of claim 1, wherein a firing is performed after the offset printing, and the plating is performed after the firing.

5. The substrate of claim 1, wherein a plated metal is heat-treated after the plating.

6. The substrate of one of claims 1 to 5, wherein the finger electrodes have an aspect ratio (height/line width) of 0.2 to 0.6.

7. The substrate of one of claims 1 to 5, the finger electrodes have a line width of 30µm to 100µm and a height of 5µm to 20µm.

8. A solar cell manufactured by using the substrate of one of claims 1 to 5, wherein an efficiency of the solar cell is twice or more of that of a solar cell manufactured by using a substrate for a solar cell having electrodes formed by an offset printing without a plating after the offset printing.

9. A method for manufacturing an electrode for a solar cell, wherein bus bar electrodes and finger electrodes being manufactured on a substrate, comprising:
a paste-electrode printing step for printing the bus bar electrodes and the finger electrodes on the substrate by an offset method using a conductive paste;
an electrode plating step for filling fine pores of the paste-electrode with an additional metal by dipping the paste-electrode into a plating solution, after the paste-electrode printing step; and
a heat treatment step for heat-treating to form an ohmic contact, after the electrode plating step.

10. The method of claim 9, further comprising:
a firing step for firing the electrode after the paste-electrode printing step.

11. The method of claim 9, wherein the bus bar electrodes are offset-printed to have a mesh shape having fine pores.

12. A solar cell comprising the electrode manufactured by the method of one of claim 9 to 11,
wherein the solar cell has a cell efficiency (Eff) of 10% or more, a fill factor (FF) of 50% or more, and a serial resistance (Rser) of 0.02Ω or less.
